Europäisches Patentamt

European Patent Office

Office européen des brevets

(19)

(11) Veröffentlichungsnummer: **0 268 024**
B1

# (12) EUROPÄISCHE PATENTSCHRIFT

(45) Veröffentlichungstag der Patentschrift:
07.03.90

(51) Int. Cl.⁴: **H01T 4/06**

(21) Anmeldenummer: 87112025.9

(22) Anmeldetag: 19.08.87

(54) **Überspannungsschutzvorrichtung für Kabeladern der Fernmeldetechnik.**

(30) Priorität: 25.10.86 DE 3636695

(43) Veröffentlichungstag der Anmeldung:
25.05.88 Patentblatt 88/21

(45) Bekanntmachung des Hinweises auf die Patenterteilung:
07.03.90 Patentblatt 90/10

(84) Benannte Vertragsstaaten:
AT BE CH DE ES FR GB GR IT LI LU NL SE

(56) Entgegenhaltungen:
EP-A- 0 038 412
DE-B- 1 112 574
DE-B- 1 249 935
US-A- 3 992 652

(73) Patentinhaber: KRONE Aktiengesellschaft,
Beeskowdamm 3-11, D-1000 Berlin 37(DE)

(72) Erfinder: Gerke, Dieter, Allmendeweg 107,
D-1000 Berlin 38(DE)
Erfinder: Biederstedt, Lutz, Breisgauer Strasse 35,
D-1000 Berlin 27(DE)

## Beschreibung

Die Erfindung bezieht sich auf eine Überspannungsschutzvorrichtung, insbesondere für Kabeladern der Fernmeldetechnik, mit mehreren zwischen Trennkontaktfahnen einer Trennleiste einsteckbaren Kontaktmessern und mit einem Erdableiter.

Aus der DE-A 30 14 796 ist eine Überspannungsableitervorrichtung dieser Art bekannt. Diese Überspannungsableitervorrichtung wird vorzugsweise für Trennleisten der Fernmeldetechnik verwendet. Zum Schutz der Kabeladern gegen Überspannungen wird die Überspannungsableitervorrichtung von oben in die Trennleiste eingesteckt. Die Überspannungsableitervorrichtung besitzt hierzu für jede ankommende und abgehende Kabelader ein nach unten ragendes Kontaktmesser, das zwischen den Trennkontaktfahnen eingesteckt wird. Die Kontaktmesser sind nach oben soweit verlängert, daß sie im Gehäuse der Überspannungsableitervorrichtung einen Pol eines Überspannungsableiters kontaktieren. Der andere Pol des Überspannungsableiters liegt an einer Erdschiene an. Im Überspannungsfall fließt somit die auf der Kabelader liegende Überspannung über einen Schneid-Klemm-Kontakt, den Trennkontakt und das Kontaktmesser zu einem Pol des Überspannungsableiters. Die Überspannung überbrückt die Funkenstrecke des mit einem Gas gefüllten Überspannungsableiters und wird zur Erdschiene abgeleitet. Im Falle der Überspannung muß der beschädigte Ableiter ausgewechselt werden. Nachteilig bei dieser Überspannungsableitervorrichtung ist, daß für jede ankommende und abgehende Kabelader ein Überspannungsableiter notwendig ist. Bei einer Trennleiste mit zehn Doppeladern bedeutet dies, daß zwanzig Ableiter notwendig sind. Darüber hinaus erfordert das Gehäuse der Überspannungsableitervorrichtung mehrere einzelne Kammern zur Aufnahme und Lagerung der Ableiter.

Nachteilig bei dieser Überspannungsschutzvorrichtung ist, daß für jede Kabelader ein Überspannungsableiter benötigt wird. Ferner besteht die Überspannungsschutzvorrichtung aus mehreren Bauteilen. So sind mehrere Kontaktfedern, ein Metallwinkel und ein Magazinstreifen notwendig. Darüber hinaus müssen die Kontaktfedern in Schlitze eingeführt und in Schlitzführungen eingefädelt werden, so daß ein erheblicher Montageaufwand entsteht.

Der Erfindung liegt von daher die Aufgabe zugrunde, eine Überspannungsschutzeinrichtung der gattungsgemäßen Art zu schaffen, die möglichst wenige Bauteile aufweist und für sämtliche, an einer Trennleiste angeschlossenen Kabeladern einen Schutz vor Überspannungen bietet.

Die Lösung dieser Aufgabe ergibt sich aus den kennzeichnenden Merkmalen des Anspruches 1. Erfindungsgemäß wird der Erdableiter zu den zwischen den Trennkontaktfahnen eingesteckten Kontaktmessern in einem definierten Abstand angeordnet, so daß ein Grobfunkenstrecke zwischen jedem Kontaktmesser und der freien Kante der elektrisch leitenden Erdleiste gebildet wird. Hieraus ergibt sich, daß im Überspannungsfall die auftretende Überspannung vom Kontaktmesser zum Erdableiter überspringt und über den Erdableiter abgeleitet wird. Der Einbau von teuren Überspannungsableitern in ein Gehäuse ist somit nicht mehr erforderlich, da die Vorrichtung nur aus wenigen Bauteilen, nämlich den Kontaktmessern und dem Erdableiter besteht.

In vorteilhafter Ausgestaltung der Erfindung sind die Kontaktmesser als Leiterbahnen ausgebildet, die auf einer Leiterplatte beidseitig nebeneinander aufgedruckt sind. Ferner besteht der Erdableiter aus einer im Querschnitt halbkreisförmig ausgebildeten Erdleiste. Das eine Ende der Leiterbahnen wird zwischen die Trennkontaktfahnen der Trennleiste eingesteckt. Das andere Ende der Leiterbahnen reicht jeweils bis unter die halbkreisförmige Leiste. Hierdurch wird erreicht, daß die Leiterbahnen zum Erdableiter einen definierten, die Grobfunkenstrecke bildenden Abstand erhalten. Durch die Ausbildung der Kontaktmesser als Leiterbahnen, die auf der Leiterplatte aufgedruckt sind, wird eine kostengünstige Herstellung aller Kontaktmesser erzielt, da alle Kontaktmesser in einem Verfahrensschritt hergestellt werden. Gleiches gilt für den Erdableiter, der für sämtliche Kabeladern und eine Trennleiste nur aus einer Leiste besteht.

In einer weiteren Ausführungsform sind die auf der Leiterplatte sich gegenüberliegenden Leiterbahnen nicht miteinander verbunden. Der Erdableiter besteht daher aus zwei halbkreisförmigen Leisten, beidseitig der Leiterplatte.

Diese Ausführungsform wird verwendet, wenn eine elektrische Trennung zwischen den ankommenden und den abgehenden Kabeladern bei gleichzeitigem Schutz gegen Überspannung gewünscht wird.

Die Verwendung einer Funkenstrecke zur Ableitung auftretender Überspannungen ist bei einem gattungsfremden Überspannungsschutz für Elektrizitätszähler aus der DE-B 1 112 574 vorbekannt. Hierbei werden jedoch in technisch aufwendiger Weise schmale, federnde Zungen aus einem metallischem Erdstreifen abgebogen, die mittels Isolierstoffdornen auf den zu erdenden Klemmen des Elektrizitätszählers aufliegen und die ferner mit Höckern versehen sind, deren Abstand zu den elektrischen Klemmen die Funkenstrecke bestimmt. Hierbei handelt es sich somit im Gegensatz zur Erfindung nicht um einen Erdableiter aus einer elektrisch leitenden Erdleiste, deren freie Kante in einem definierten, eine Grobfunkenstrecke bildenden Abstand über alle Kontaktmesser verläuft.

Die Erfindung ist nachfolgend anhand von zwei in den Zeichnungen dargestellten Ausführungsbeispielen von Überspannungsschutzvorrichtungen näher erläutert. Es zeigen:

Fig. 1 eine Perspektivansicht auf die Vorderseite der ersten Ausführungsform,
Fig. 2 eine Perspektivansicht auf die Rückseite,
Fig. 3 einen Querschnitt durch die erste Ausführungsform und
Fig. 4 einen Querschnitt durch die zweite Ausführungsform.

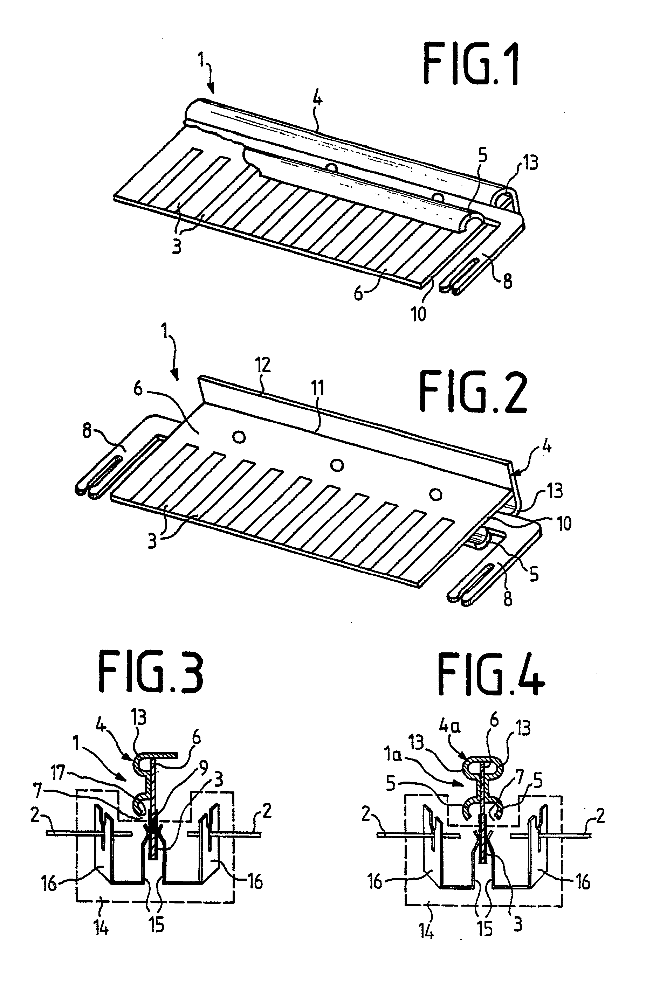

In der ersten Ausführungsform besteht die Überspannungsschutzvorrichtung 1 - wie die Figuren 1 bis 3 zeigen - aus einer Leiterplatte 6 und aus einem Erdableiter 4. Auf die rechteckig ausgebildete Leiterplatte 6 sind beidseitig mehrere nebeneinander liegende, die Kontaktmesser 3 bildende Leiterbahnen aufgedruckt. In dieser ersten Ausführungsform sind - wie die Figur 3 zeigt - jeweils zwei sich auf beiden Seiten gegenüberliegende Kontaktmesser 3 miteinander durch eine Durchkontaktierung 9 verbunden. Die nebeneinander angeordneten Kontaktmesser 3 verlaufen hierbei parallel zu den Schmalseiten 10 der Leiterplatte 6.

Die Kontaktmesser 3 verlaufen nicht über die ganze Breite der Leiterplatte 6, sondern enden bereits nach etwa 2/3 der Breite der Leiterplatte 6. Auf dem freien Drittel der Leiterplatte 6 ist auf einer Seite der Leiterplatte 6 über eine Schraub-, Löt- oder Klemmverbindung der Erdableiter 4 angeordnet, der als eine im Querschnitt halbkreisförmig Leiste 5 ausgebildet ist. Zwischen dem freien Randbereich der halbkreisförmigen Leiste 5 der Erdleiste 4 und den Kontaktmessern 3, die unter der halbkreisförmigen Leiste 5 enden, besteht somit ein definierter, eine Grobfunkenstrecke bildender Abstand 7. Das andere Ende des Erdableiters 4 ist über seine Längsseite um etwa 90° über die Längsseite 11 der Leiterplatte 6 zur anderen Leiterplattenseite hin abgebogen und steht soweit über, daß eine Ziehkante 12 gebildet wird. Da ein Mindestbiegeradius eingehalten werden muß, kann die Abbiegung um 90° nicht scharfkantig über die Längsseite 11 erfolgen. Es ist somit eine weitere, dem Querschnitt der halbkreisförmigen Leiste 5 entsprechende halbkreisförmige Leiste 13 vorgesehen. Diese halbkreisförmige Leiste 13 und die Ziehkante 12 erleichtern das Herausziehen der in eine Trennleiste 14 eingesteckten Überspannungsschutzvorrichtung 1 (Fig. 3). An den Schmalseiten 10 der Leiterplatte 6 ist an den Erdableiter 4 jeweils ein gabelförmiger Erdkontakt 8 angeordnet. Diese erste Ausführungsform der Überspannungsschutzvorrichtung 1 1wird verwendet, wenn beim Einstecken der Überspannungsschutzvorrichtung 1 in die Trennleiste 14 (zum gleichzeitig Schutz gegen Überspannungen) keine Trennung zwischen der ankommenden und abgehenden Kabelader 2 erfolgen soll.

In der Fig. 4 ist eine zweite Ausführungsform einer Überspannungsschutzvorrichtung 1a dargestellt, die in die Trennleiste 14 eingesteckt wird, wenn bei gleichzeitigem Schutz gegen Überspannungen eine Trennung zwischen der ankommenden und der abgehenden Kabelader 2 gewünscht wird. Diese zweite Ausführungsform unterscheidet sich von der ersten dadurch, daß die zwei sich auf beiden Seiten der Leiterplatte 6 gegenüberliegenden Kontaktmesser 3 elektrisch nicht miteinander verbunden sind und daß der Erdableiter 4a aus zwei halbkreisförmigen Leisten 5 besteht, die auf beiden Seiten der Leiterplatte 6 angeordnet und einteilig ausgebildet sind. Es sind auch hier zwei weitere halbkreisförmige Leisten 13 durch Abbiegungen entstanden, die in dieser Ausführungsform auf beiden Seiten der Leiterplatte 6 angeordnet und als Griffleiste ausgebildet sind, welche das Herausziehen der Überspannungsschutzvorrichtung 1 a aus der Trennleiste 14 erleichtern.

Im Überspannungsfall gelangt die Überspannung von der Kabelader 2 über den Schneidklemmkontakt 16 und den Trennkontakt 15 zum Kontaktmesser 3, von wo die Überspannung zum Erdableiter 4, 4 a überspringt. Der Erdableiter 4, 4 a ist mit einer der Erde verbundenen, nicht dargestellten Montagewanne über die gabelförmigen Erdkontakte 8 verbunden. In der ersten Ausführungsform gelangt die auf der ankommenden oder abgehenden Kabelader 2 liegende Überspannung immer auf die, auf einer Seite der Leiterplatte 6 angeordnete halbkreisförmige Leiste 5, da beide sich gegenüberliegenden Kontaktmesser 3 miteinander verbunden sind.

In der zweiten Ausführungsform sind die beiden sich gegenüberliegenden Kontaktmesser 3 elektrisch voneinander getrennt, so daß hier die Überspannung entweder auf der einen oder anderen Seite der Leiterplatte 6 auf den Erdableiter 4 a überspringt, abhängig davon, ob die Überspannung auf der ankommenden oder abgehenden Kabelader 2 anliegt.

## Bezugszeichenliste

1, 1a Überspannungsschutzvorrichtung
2 Kabeladern
3 Kontaktmesser
4, 4a Erdableiter
5 halbkreisförmige Leiste
6 Leiterplatte
7 definierter Abstand
8 Erdkontakt
9 Durchkontaktierung
10 Schmalseite
11 Längsseite
12 Ziehkante
13 halbkreisförmige Leiste
14 Trennleiste
15 Trennkontakt
16 Klemmkontakt
17 Kante

## Patentansprüche

1. Überspannungsschutzvorrichtung, insbesondere für Kabeladern der Fernmeldetechnik, mit mehreren zwischen Trennkontaktfahnen einer Trennleiste einsteckbaren Kontaktmessern und mit einem Erdableiter, dadurch gekennzeichnet, daß der Erdableiter (4, 4a) aus einer elektrisch leitenden Erdleiste (5) besteht, deren freie Kante (17) in einem definierten, eine Grobfunkenstrecke bildenden Abstand (7) quer über alle Kontaktmesser (3) verläuft.

2. Schutzvorrichtung nach Anspruch 1, dadurch gekennzeichnet, daß die Kontaktmesser (3) als Leiterbahnen ausgebildet sind, die auf einer Leiterplatte (6) beidseitig nebeneinander aufgedruckt sind und daß der Erdableiter (4, 4a) im Querschnitt halbkreisförmig ausgebildet ist.

3. Schutzvorrichtung nach Anspruch 2, dadurch gekennzeichnet, daß die auf beiden Seiten der Leiterplatte (6) gegenüberliegenden Kontaktmesser (3) elektrisch voneinander getrennt sind.

4. Schutzvorrichtung nach einem der Ansprüche 1 bis 3, dadurch gekennzeichnet, daß zwei auf beiden Seiten der Leiterplatte (6) gegenüberliegende Kontaktmesser (3) miteinander durch Durchkontaktierungen (9) verbunden sind.

5. Schutzvorrichtung nach einem der Ansprüche 1 bis 4, dadurch gekennzeichnet, daß beidseitig der Leiterplatte (6) ein Erdableiter (4a) mit zwei halbkreisförmigen Leisten (5) angeordnet ist.

## Claims

1. A voltage surge arrester device, in particular for telecommunication conductors, comprising several contact knives to be inserted between disconnector contact lugs of a connector bank, and comprising an earth arrester, characterised by that the earth arrester (4, 4a) consists of an electrically conductive earth bank (5), the free edge (17) of which extends in a defined distance (7) laterally to all contact knives (3), said distance forming a coarse spark gap.

2. A voltage surge arrester device according to claim 1, characterised by that the contact knives (3) are formed as printed-circuit tracks, which are printed side-by-side on either side of a printed-circuit board (6), and that the earth arrester (4, 4a) has a semi-circular cross-section.

3. A voltage surge arrester device according to claim 2, characterised by that the contact knives (3) arranged opposite to each other on either side of the printed-circuit board (6) are electrically separated from each other.

4. A voltage surge arrester device according to one of claims 1 to 3, characterised by that two contact knives (3) arranged opposite to each other on either side of the printed-circuit board (6) are electrically connected to each other by through-contacts (9).

5. A voltage surge arrester device according to one of claims 1 to 4, characterised by that on either side of the printed-circuit board (6), an earth arrester (4a) with two semi-circular banks (5) is provided.

## Revendications

1. Dispositif de protection contre les surtensions, en particulier pour conducteurs de télécommunications, comprenant plusieurs lames de contact à ficher entre les lames des contacts de coupure d'une réglette de coupure, et comprenant un conducteur à la terre, caractérisé en ce que le conducteur à la terre (4, 4a) est formé d'une réglette de terre (5) électroconductrice, l'arête libre (17) de celle-ci s'étendant en une distance définie (7) latéralement sur tous les lames de contact (3), ladite distance définie formant une distance de décharge grosse.

2. Dispositif de protection contre les surtensions selon la revendication 1, caractérisé en ce que les lames de contact (3) sont réalisées sous la forme de pistes conductives, qui sont imprimées l'une à côté de l'autre sur les deux faces d'une carte imprimée (6), et que le conducteur à la terre (4, 4a) est pourvu d'une section transversale en forme demi-circulaire.

3. Dispositif de protection contre les surtensions selon la revendication 2, caractérisé en ce que les lames de la carte imprimée (6) sont séparées électriquement l'une de l'autre.

4. Dispositif de protection contre les surtensions selon les revendications 1 à 3, caractérisé en ce que deux lames de contact (3) opposées aux deux faces de la carte imprimée (6) sont raccordées électriquement l'une à l'autre.

5. Dispositif de protection contre les surtensions selon une des revendications 1 à 3, caractérisé en ce qu'aux deux faces de la carte imprimée (6), un conducteur à la terre (4a) comprenant deux réglettes (5) demi-circulaires est prévu.

FIG.1

FIG.2

FIG.3

FIG.4